Europäisches Patentamt

European Patent Office

Office européen des brevets

(11) Veröffentlichungsnummer: **0 468 131 A1**

# EUROPÄISCHE PATENTANMELDUNG

(21) Anmeldenummer: **91102059.2**

(22) Anmeldetag: **14.02.91**

(51) Int. Cl.⁵: **G11C 11/34**, G11B 25/04

(30) Priorität: **25.06.90 DE 4020154**

(43) Veröffentlichungstag der Anmeldung:
**29.01.92 Patentblatt 92/05**

(84) Benannte Vertragsstaaten:
**AT CH DE DK ES FR GB IT LI NL**

(71) Anmelder: **ROBERT BOSCH GmbH**
**Postfach 10 60 50**
**W-7000 Stuttgart 10(DE)**

(72) Erfinder: **Eggert, Albert, Dipl.-Ing.**
**Gatower Strasse 149**
**W-1000 Berlin 20(DE)**
Erfinder: **Müller, Manfred, Dipl.-Ing.**
**Säntisstrasse 142a**
**W-1000 Berlin 48(DE)**
Erfinder: **Wiener, Peter, Dipl.-Ing.**
**Tacitusstrasse 7**
**W-1000 Berlin 42(DE)**

(74) Vertreter: **Schmidt, Hans-Ekhardt, Dipl.-Ing.**
**Robert Bosch GmbH Geschäftsbereich**
**Mobile Kommunikation Patent- und**
**Lizenzabteilung Forckenbeckstrasse 9-13**
**W-1000 Berlin 33(DE)**

(54) **Speicherelement.**

(57) 2.1 Es ist üblich, die gerätespezifischen Daten eines Hörgerätes vor der Auslieferung an den Hörbehinderten in eine Karteikarte einzutragen. Die zu lösende Aufgabe besteht darin, ein Speicherelement derart weiterzubilden, daß es möglichst einfach zu handhaben und universell anzuwenden ist.

2.2 Das erfindungsgemäße Speicherelement ist derart ausgebildet, daß es die gerätespezifischen Daten elektronisch oder magnetisch speichert. Das Speicherelement ist vorzugsweise ein in oder auf einer Karte untergebrachter Halbleiterspeicher.

EP 0 468 131 A1

Die Erfindung geht von einem Speicherelement nach dem Oberbegriff des Anspruchs 1 aus.

## Stand der Technik

Es sind derartige Speicherelemente bekannt, die zum Beispiel die Form eines Datenblattes oder einer Karteikarte haben, welche vor der Übergabe eines an das Gehör eines Hörgeräteträgers angepaßten Hörgerätes von dem Ausliefernden handschriftlich ausgefüllt und bei ihm und/oder bei dem Hörgeräteträger aufbewahrt wird. Bei einer eventuell später notwendig werdenden Reparatur oder Neueinstellung der Übertragungscharakteristik des Hörgerätes stehen dann die in der Karteikarte eingetragenen Daten zur Verfügung. Die Handhabung der Karteikarten ist in der Praxis umständlich, und die Einsatzmöglichkeiten sind begrenzt.

## Aufgabe

Der Erfindung liegt die Aufgabe zugrunde, ein Speicherelement gemäß dem Oberbegriff des Anspruchs 1 derart weiterzubilden, daß eine möglichst einfache und universelle Anwendbarkeit gegeben ist.

## Lösung

Diese Aufgabe wird bei einem Speicherelement gemäß dem Oberbegriff des Anspruchs 1 durch die im kennzeichnenden Teil dieses Anspruchs angegebenen Merkmale gelöst. Die mit der Erfindung erzielbaren Vorteile bestehen insbesondere darin, daß das Speicherelement eine Vielzahl hörgerätespezifischer Daten speichern kann und daß das Eingeben und Auslesen der gespeicherten Daten mittels eines Computers, zum Beispiel eines Personal-Computers (PC), möglich ist. Darüber hinaus hat die Erfindung den Vorteil, daß die für die individuelle Anpassung digitaler Hörgeräte benötigte Software für ein Programmiergerät ebenfalls in einem Speicherelement, vorzugsweise in einer Chipkarte, gespeichert werden kann und daß dadurch auch leicht nachträgliche Änderungen der Programmiergerät-Software durchgeführt werden können, indem die Chipkarte zum Beispiel in eine entsprechende Öffnung des Programmiergerätes eingeschoben und die in dem Speicherelement gespeicherte Software automatisch auf das Programmiergerät übertragen wird.

## Beschreibung der Erfindung

Der ein Hörgerät an einen Hörgeräteträger Ausliefernde, das ist zum Beispiel ein Hörgeräteakustiker, überträgt in ein Speicherelement, das ist vorzugsweise eine Chipkarte, alle für das betreffende Hörgerät relevanten Daten, wie zum Beispiel die Gerätenummer, Kundendaten, das Garantiedatum und die Parameter der aufgrund der Hörbehinderung individuell eingestellten Übertragungscharakteristik des Hörgerätes. Die Chipkarte kann in bekannter Weise einen RAM-, ROM-, PROM-, EEPROM-, EPROM- oder ähnlichen Halbleiterspeicher enthalten. Das Einspeichern der zu speichernden Hörgerätedaten erfolgt mittels der zu einem Computer gehörenden Tastatur. Handelt es sich bei dem Hörgerät um ein digitales Hörgerät, dann können die in dem Hörgerät gespeicherten Parameter direkt in die Chipkarte übernommen werden.

Ist später eine Reparatur oder eine Neueinstellung des Hörgerätes erforderlich, dann stehen demjenigen, der das Hörgerät an den Endkunden geliefert hat, oder demjenigen, dem der Hörgeräteträger seine Chipkarte übergibt, alle gerätespezifischen Daten zur Verfügung, die auf einem Bildschirm des Computers angezeigt werden können.

Ändert sich im Laufe der Zeit die für das Programmieren digitaler Hörgeräte erforderliche Software, dann kann die neue Software in einer besonderen Chipkarte gespeichert werden, die der Ausliefernde von dem Hersteller erhält. Der Ausliefernde kann dann sein Programmiergerät mit der neuen Chipkarte umprogrammieren.

## Patentansprüche

1. Speicherelement für gerätespezifische Daten von Hörgeräten, wie zum Beispiel die Gerätenummer, Kundendaten, das Garantiedatum, Parameter der Übertragungscharakteristik des Hörgerätes usw., **dadurch gekennzeichnet**, daß das Speicherelement derart ausgebildet ist, daß es die gerätespezifischen Daten elektronisch oder magnetisch speichert.

2. Speicherelement nach Anspruch 1, dadurch gekennzeichnet, daß das Speicherelement ein auf oder in einer Karte untergebrachter Halbleiterspeicher ist.

3. Speicherelement nach Anspruch 1, dadurch gekennzeichnet, daß das Speicherelement eine Karte mit Magnetstreifen ist.

## EINSCHLÄGIGE DOKUMENTE

EP 91102059.2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.⁵) |
|---|---|---|---|
| X | **EP - A - 0 335 542** (DIAPHON DEVELOPMENT)   * Abstract; column 1, line 1 – column 2, line 55; claim 1 * -- | 1 | H 04 R 25/00 G 11 C 11/34 G 11 B 25/04 |
| X | **EP - A - 0 341 995** (MINNESOTA MINING AND MANUF. COMPANY)   * Abstract; column 1, line 1 – column 5, line 4; claims 6-10 * ---- | 1 | |

| RECHERCHIERTE SACHGEBIETE (Int. Cl.⁵) |
|---|
| H 04 R A 61 B G 11 C G 11 B |

Der vorliegende Recherchenbericht wurde für alle Patentansprüche erstellt.

| Recherchenort | Abschlußdatum der Recherche | Prüfer |
|---|---|---|
| WIEN | 27-11-1991 | GRÖSSING |